# EUROPÄISCHE PATENTSCHRIFT

(11) **EP 2 042 953 B1**
(45) Veröffentlichungstag und Bekanntmachung des Hinweises auf die Patenterteilung: **01.08.2018**
(21) Anmeldenummer: 08015620.1
(22) Anmeldetag: 05.09.2008
(51) Int. Cl.: G05B 19/042, H05K 7/14

(54) **Steuerungsblock mit einer Punkt-zu-Punkt- Kommunikation zwischen einem an einen Datenbus anzuschaltenden Steuerungs-Mastermodul und Erweiterungs-Slavemodulen**
Control block with point-to-point communication between a control master module which is activated on a data bus and expansion slave modules
Bloc de commande doté d'une communication point à point entre un module maître de commande devant être raccordé à un bus de données et des modules esclaves d'élargissement

(30) Priorität: 26.09.2007 DE 102007046178
(43) Veröffentlichungstag der Anmeldung: 01.04.2009
(73) Patentinhaber: Phoenix Contact GmbH & Co. KG, 32825 Blomberg (DE)
(72) Erfinder: Konieczny, Frank, 32657 Lemgo (DE); Krumsiek, Dietmar, 31860 Emmerthal (DE)
(74) Vertreter: Blumbach · Zinngrebe Patent- und Rechtsanwälte

(56) Entgegenhaltungen:
- EP-A1- 1 577 723
- DE-A1-102004 056 243
- DE-A1-102005 025 703
- US-A- 5 493 194
- US-A1- 2003 005 196

## Beschreibung

Die Erfindung betrifft einen Ein-/Ausgangskanal-Steuerungsblock, welcher eine Anzahl aufeinanderfolgenden Ein-/Ausgangs-Modulen umfasst, wobei das erste ein Ein-/Ausgangs-Steuerungs-Mastermodul ist und die nachfolgenden Ein-/Ausgangs-Erweiterungs-Slavemodule sind, sowie ein entsprechendes Steuerungs-Mastermodul und Erweiterungs-Slavemodul.

Insbesondere im Bereich der Automatisierungstechnik bei der Automatisierung von komplexen logischen Verknüpfungen, Fehlervorgängen oder Zeitabläufen werden Zeitrelais, Zähler oder Relais den Anforderungen nach einem Universalsteuergerät häufig nur bedingt gerecht. US5493194 betrifft einen Steuerungsblock gemäss dem Stand der Technik. Komplexe SPS (speicherprogrammierbare Steuerungs-)Systeme wiederum sind in ihren technischen Ausstattungsmerkmalen oftmals überdimensioniert und folglich auch in der Produktion zu teuer.

Um diese Lücke zu schließen, sind kompakte Steuerungsmodule bekannt, die dem Anwender den Vorteil bieten, dass er mit nur noch einer Automatisierungskomponente eine große Anzahl von Applikationen aus dem unteren Leistungsbereich realisieren kann. Je nach Typ und Erweiterung können mit solchen derzeitig am Markt erhältlichen kompakten Steuerungsmodulen zwischen 4 und 48 Eingänge oder Ausgänge, nachfolgend als E/A bezeichnet, verarbeitet werden. Ein über einen Eingang von einem Busendteilnehmer, wie z.B. einem Sensor, kommendes Signal wird von dem Steuerungsmodul verarbeitet und/oder an einen Datenbus geführt und über einen Ausgang wird ein von dem Datenbus kommendes Signal oder ein über einen Eingang kommendes, verarbeitetes Signal an einen Busendteilnehmer, wie z.B. einen Aktor, geführt.

Ein solches kompaktes E/A-Steuerungsmodul verknüpft somit in der Regel von Eingangsmodulen stammende Signale entsprechend einer bestimmten Steuerungslogik und gibt darauf hin Signale über die Ausgangsmodule aus.

Die Anzahl und Typen der E/A-Kanäle der heutigen kompakten E/A-Steuerungsmodule sind jedoch fest und umfassen z.B. 2 Eingänge und 2 Ausgänge, wobei beispielsweise 1 Eingang für digitale Signale und 1 Eingang für analoge Signale vorgesehen sind.

Die Verknüpfung der Eingangssignale und Generierung der Ausgangssignale durch das kompakte Steuerungsmodul erfolgt somit für die feste Anzahl von E/A-Kanälen. Den E/A-Kanälen können feste physikalische Schnittstellen zur Anbindung zugeordnet sein, so dass die Eingangs-/Ausgangsmodule z.B. in entsprechende Steckplätze gesteckt sind. Alternativ können den E/A-Kanälen am Steuerungsmodul auch logische Schnittstellen zugeordnet sein, so dass die Anbindung jedes Eingangs-/Ausgangsmoduls an das Steuerungsmodul über eine gemeinsame physikalische Schnittstelle unter Verwendung eines Datenbusses erfolgt.

Ein wesentlicher Nachteil des Standes der Technik ist somit grundsätzlich, dass es bei solchen Steuerungsmodulen immer nur eine feste Anzahl von Ein- und Ausgängen gibt. Jede Erweiterung von E/A-Kanälen ist kostenintensiv und kann in der Regel nur unter zusätzlicher Verwendung des oder eines weiteren Datenbusses erfolgen.

Zumindest bei Verwendung eines Datenbusses bedarf es darüber hinaus einer Adressierung der Eingangs-/Ausgangsmodule.

Eine Aufgabe der Erfindung besteht somit darin, ein Weg aufzuzeigen, mit welchem die Anzahl von händelbaren Anschlüssen eines vorstehend aufgezeigten, gattungsbildenden kompakten E/A-Steuerungsmoduls auf einfache Weise erweiterbar ist.

Erfindungsgemäße Lösungen der Aufgabe sind durch Gegenstände mit den Merkmalen der unabhängigen Ansprüche gegeben. Vorteilhafte und/oder bevorzugte Ausführungsformen und Weiterbildungen sind Gegenstand der weiteren Ansprüche.

Die Erfindung schlägt somit einen kompakten Ein-/Ausgangskanal-Steuerungsblock vor, welcher eine Anzahl von aufeinanderfolgenden Ein-/Ausgangs-Modulen umfasst, wobei das erste ein Ein-/Ausgangs-Steuerungsmodul bzw. Mastermodul ist und die nachfolgenden Ein-/Ausgangs-Erweiterungsmodule bzw. Slavemodule sind. Jedes erfindungsgemäß vorgeschlagenes Erweiterungs-Slavemodul umfasst eine Verarbeitungslogik sowie jeweils einen ersten Signalport und jeweils eine gleiche Anzahl von zweiten Signalports und eine gleiche Anzahl von dritten Signalports besitzen, die zweckmäßig stets an gleichen Positionen jedes Erweiterungs-Slavemoduls angeordnet sind, wobei der erste Signalport mit der Verarbeitungslogik, zu welcher wenigstens ein vierter Signalport zum Verbinden eines Ein-/Ausgangs-Busendteilnehmers gehört, und jeweils ein zweiter Signalport mit einem dritten Signalport verbunden ist. Ein erfindungsgemäß vorgeschlagenes Steuerungs-Mastermodul besitzt ebenfalls eine Anzahl von dritten Signalports und eine Steuerlogik zum Datenaustausch mit einem Datenbus und zum gezielten Ansteuern dieser Signalports. Das Steuerungs-Mastermodul und die Erweiterungs-Slavemodule werden derart miteinander verbunden, dass jeweils der gleiche aus der Anzahl der dritten Signalports eines vorangehenden Moduls mit dem ersten Signalport eines nachfolgenden Moduls verbunden ist, und jeder weitere Signalport der Anzahl von dritten Signalports mit jeweils einem Signalport der Anzahl von zweiten Signalports des nachfolgenden Moduls verbunden ist.

Aufgrund des damit gewährleisteten modularen Bereitstellens von anwendungsspezifisch benötigten Erweiterungs-Slavemodulen, ist die Anzahl von durch ein kompaktes E/A-Steuerungs-Mastermodul steuerbaren Anschlüssen auf einfache Weise und individuell erweiterbar und kommt den im Industriebereich bestehenden Bedürfnissen an effizienten, platzsparenden und dennoch kostengünstigen Lösungen wesentlich entgegen. Auch kann auf eine spezifische Adressierung der jeweiligen Erweiterungs-Slavemodule verzichtet werden, da alle Erweiterungs-Slavemodule gleichartig aufgebaut sind und die jeweilige Adressierung durch die Aneinanderschaltung der einzelnen Erweiterungs-Slavemodule entsprechend definiert ist.

Zweckmäßig können die Ein-Ausgangskanäle der ersten, zweiten und dritten Signalports somit zur Signalübertragung mittels Punkt-zu-Punkt-Kommunikation angepasst sein.

Folglich können bereits bekannte Systeme zur Punkt-zu-Punkt-Kommunikation, wie z.B. das als IO-Link bekannte Kommunikationssystem für den Anschluss von Sensoren und Aktoren, eingesetzt werden.

Die Erfindung sieht folglich zweckmäßig ferner eine Steuerlogik vor, die eine Einrichtung zur Verarbeitung von Signalen zur Punkt-zu-Punkt-Kommunikation und für eine Bus-Kommunikation besitzt.

Ferner besitzt die Verarbeitungslogik in praktischer Ausführung eine Einrichtung zur Verarbeitung von Signalen zur Punkt-zu-Punkt-Kommunikation, wobei die Verarbeitungslogik darüber hinaus bevorzugt zur Verarbeitung von digitalen oder analogen Standard-Ein-/Ausgangskanalsignalen angepasst ist.

Bei besonders bevorzugten Ausführungsformen stellen die vierten Ports somit insbesondere digitale oder analoge Standard-Ein-/Ausgangskanalsignale bereit und können jedoch ergänzend oder alternativ auch Punkt-zu-Punkt-Kommunikations-Ports umfassen.

Ist die Anzahl der dritten Signalports gemeinsam an einer ersten Gehäuseseite angeordnet und sind, soweit vorhanden, die ersten und zweiten Signalports gemeinsam an einer zweiten Gehäuseseite, die der ersten gegenüberliegt, angeordnet, kann jede Punt-zu-Punkt-Kommunikationsverbindung auf die jeweils andere Gehäuseseite derart rangiert werden und die Module somit auf einfachste Weise benachbart aneinandergereiht werden, dass jeder Port automatisch mit den jeweils richtigen nachfolgenden Port gekoppelt wird. So ist hierbei zweckmäßig vorgesehen, die ersten, zweiten und dritten Signalports an jeweiligen Steck- oder Klemmkomponenten anzuschließen bzw. zu integrieren.

Ein weiterer Vorteil ist darin zu sehen, dass die Signalports nicht ausschließlich zur leitungsgebundenen Signalübertragung ausgebildet sein müssen sondern alternativ auch zur leitungsungebunden Signalübertragung, z.B. mittels entsprechender WLAN- oder Bluetooh Sende-/Empfangseinrichtungen, ausgebildet sein können.

Besonders bevorzugte Ausführungsformen besitzen somit solche Erweiterungs-Slavemodule, die eine erste Reihe einer Anzahl von Punkt-zu-Punkt-Kommunikation-Ports und eine zweite Reihe der Anzahl von Punkt-zu-Punkt-Kommunikation-Ports integrieren, wobei der in der ersten Reihe von Ports erste Port über eine Punkt-zu-Punkt-Kommunikationsverbindung mit einer an wenigstens einen Anschlussport gekoppelten Verarbeitungseinheit verbunden ist und wobei die nachfolgenden Ports der ersten Reihe von Ports jeweils der Reihe nach über eine Punkt-zu-Punkt-Kommunikationsverbindung mit den Ports der zweiten Reihe von Ports, beginnend mit dem ersten Port in der zweiten Reihe von, verbunden sind.

Um die Erfindung auch auf Gebieten einzusetzen, bei denen sicherheitskritische Daten übertragen werden müssen, z.B. um zeitnah sicherheitsrelevante Maßnahmen einzuleiten, ist es von weiterem Vorteil, dass die Punkt-zu-Punkt-Kommunikation auf einem sicherheitsgerichteten Protokoll basiert, welches für den Einsatz von Sicherheitssensoren und -aktoren geeignet ist.

Ferner ist bei besonders praktischen Ausführungsformen vorgesehen, dass die Erweiterungs-Slavemodule zwischen dem Steuerungs-Mastermodul und einer Spannungsversorgungseinrichtung angeordnet sind, und jedes Modul über zueinander ausgerichtete Spannungsverteilungseinrichtungen verfügt, so dass alle Module mittels der über die Spannungsversorgungseinrichtung eingespeiste Spannung betrieben werden.

Die Erfindung wird nachfolgend anhand einiger Ausführungsbeispiele unter Bezugnahme auf die beigefügten Zeichnungen näher beschrieben. In den Zeichnungen zeigen
Fig. 1 eine Prinzipskizze eines Steuerungsblocks nach der Erfindung mit einem gattungsgemäßen Steuerungs-Mastermodul, das eine Anzahl von Punkt-zu-Punkt-Kommunikations-Ports integriert, und vier weiteren, mit dem Steuerungs-Mastermodul koppelbaren Erweiterungs-Slavemodulen,
Fig. 2 eine Prinzipskizze einer bevorzugten Weiterbildung des Steuerungsblocks, wobei die Punkt-zu-Punkt-Kommunikations-Ports eines jeweiligen Moduls an zu benachbarten Modulen blickenden Gehäuseseiten angeordnet sind,
Fig. 3 eine Prinzipskizze einer Ausführungsform, bei welcher die Erweiterungs-Slavemodule digitale und/oder analoge Standard-Ein-/Ausgangskanäle besitzen,
Fig. 4 eine Prinzipskizze zur Veranschaulichung eines Prozessabbildes einer Ausführungsform, bei welcher ein Erweiterungs-Slavemodul noch wenigstens einen weiteren Punkt-zu-Punkt-Kommunikations-Port besitzt, und
Fig. 5a bis c Prinzipskizzen von verschiedenen nach der Erfindung einsetzbaren Erweiterungsoptionen.

Zur näheren Beschreibung der Erfindung wird auf die beigefügten Figuren Bezug genommen. Soweit nicht explizit ausgeführt, ist davon auszugehen, dass einzelne Merkmale auch auf unterschiedliche Weise im Rahmen der Erfindung miteinander kombiniert werden können.

Der Einfachheit halber wird für die nachfolgende Beschreibung bei den in den Figuren schematisch dargestellten Punkt-zu-Punkt-Kommunikations-Ports davon ausgegangen, dass diese für eine an sich als "IO-Link" bekannte Punkt-zu-Punkt-Kommunikationsverbindung angepasst sind, wobei der IO-Link auf einer Punkt-zu-Punkt-Datenübertragung mittels Drei-Draht-Anschlusstechnik basiert. Für den Fachmann ist jedoch ersichtlich, dass Punkt-zu-Punkt-Kommunikations-Ports nicht zwingend zur leitungsgebundenen Signalübertragung ausgebildet sein müssen sondern alternativ auch zur leitungsungebunden Signalübertragung, z.B. mittels entsprechender WLAN- oder Bluetooth- Sende-/Empfangseinrichtungen, ausgebildet sein können.

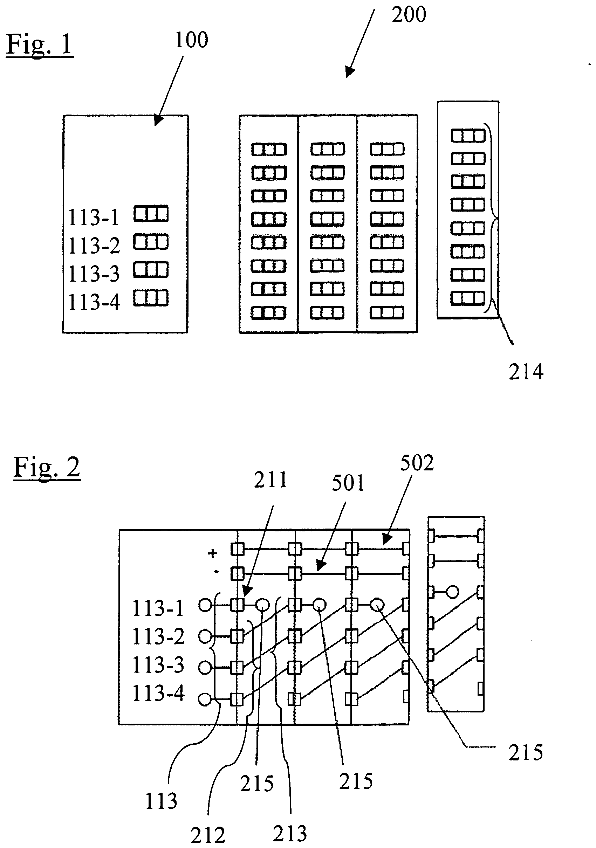

In den Figuren 1 bis 3 sind unterschiedliche Aspekte beispielhafter bevorzugter kompakter Ein-/Ausgangskanal-Steuerungsblöcke gemäß der Erfindung schematisch dargestellt. Die Steuerungsblöcke umfassen jeweils ein Ein-/Ausgangs-Steuerungs-Mastermodul 100 sowie vier elektrisch nachfolgende Ein-/Ausgangs-Erweiterungs-Slavemodule 200. Jedes dieser Slavemodule 200 umfasst jeweils einen ersten Signalport 211 und jeweils eine gleiche Anzahl von zweiten Signalports 212 und eine gleiche Anzahl von dritten Signalports 213. In den Figuren umfasst jedes Slavemodul 200 drei zweite Signalports 212 und vier dritte Signalports 213. Diese sind zweckmäßig, wie nachfolgend ersichtlich wird, stets an gleichen Positionen jedes Erweiterungs-Slavemoduls angeordnet. Der erste Signalport 211 eines Erweiterungs-Slavemoduls ist jeweils mit einer Verarbeitungslogik 215 des selben Erweiterungs-Slavemoduls 200 verbunden, wobei zu der Verarbeitungslogik 215 eine Anzahl von vierten Signalports 214 gehören, die mit der Verarbeitungslogik 215 durch, in den Figuren nicht dargestellte, Verbindungen zum Verbinden von Ein-/Ausgangs-Busendteilnehmers, wie z.B. Sensoren und Aktoren 310, verbunden sind. Ferner ist jeweils ein zweiter Signalport 212 eines Erweiterungs-Slavemoduls 200 mit einem dritten Signalport 213 des selben Erweiterungs-Slavemoduls 200 verbunden.

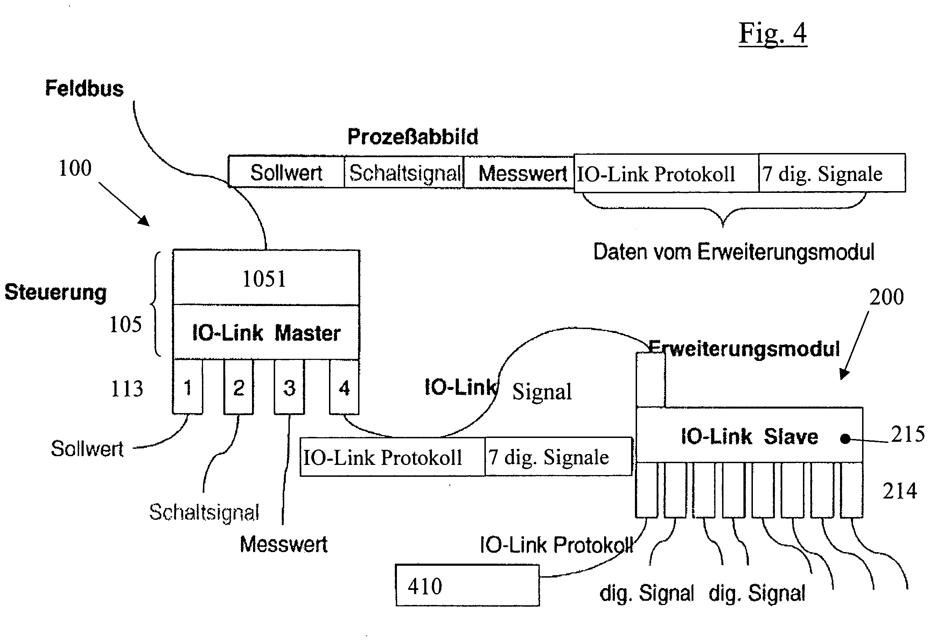

Das kompakte E/A-Steuerungs-Mastermodul 100 besitzt ebenfalls eine Anzahl von dritten Signalports 113 und, wie an einem Beispiel detaillierter bei Fig. 4 zu sehen, eine Steuerlogik zum Datenaustausch mit einem Datenbus und zum gezielten Ansteuern dieser Signalports 113. Die Steuerlogik 105 verknüpft grundsätzlich über Eingangsmodulen stammende Signale, entsprechend einer bestimmten Steuerungslogik und gibt entsprechend der bestimmten Steuerungslogik Signale über die Ausgangsmodule aus. Gemäß den Figuren besitzt das Steuerungs-Mastermodul 100 eine Anzahl von vier dritten Signalports 113, in den Figuren mit 113-1, 113-2, 113-3 und 113-4 gekennzeichnet.

Alle ersten, zweiten und dritten Signalports 113 sind zur Signalübertragung mittels Punkt-zu-Punkt-Kommunikation angepasste Signalports, und also gemäß obiger Vereinfachung in den Figuren auf einer Punkt-zu-Punkt-Datenübertragung mittels Drei-Draht-Anschlusstechnik basierte IO-Link-Ports.

Durch Integration des Mastermoduls 100 mit nur einigen Punkt-zu-Punkt-Kommunikations-Ports, an welche grundsätzlich Standard-Sensoren und -Aktoren sowie weitere Punkt-zu-Punkt-Kommunikations fähige Busendteilnehmer anschließbar sind, können somit auch erfindungsgemäße Erweiterungs-Slavemodule angeschlossen werden, welche dann zur Erweiterung der Anzahl von steuerbaren bzw. händelbaren Anschlüssen des Steuerungs-Mastermoduls 100 eine weitere Anzahl von Ports 214 in Form von Standard Ein-/Ausgängen oder auch weitere Punkt-zu-Punkt-Kommunikations-Ports zur Verfügung stellen.

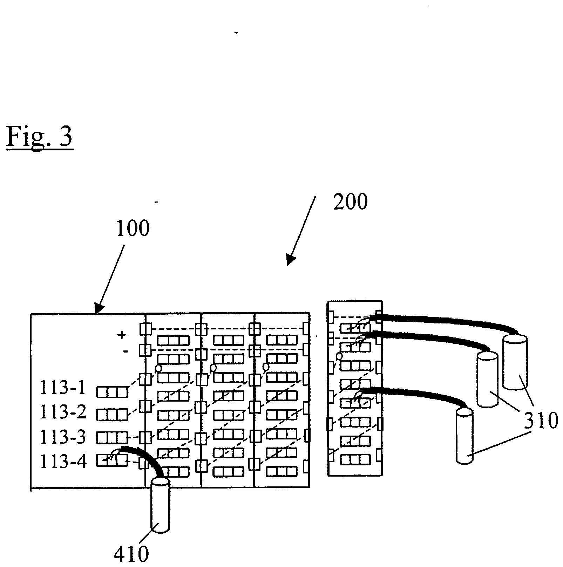

Dadurch, dass, wie bei Fig. 2 und 3 gezeigt, nach der Erfindung jeweils der gleiche aus der Anzahl der dritten Signalports eines vorangehenden Moduls 100, 200 mit dem ersten Signalport eines nachfolgenden Moduls 200 verbunden ist, und jeder weitere Signalport der Anzahl von dritten Signalports des vorangehenden Moduls 100, 200 mit jeweils einem Signalport der Anzahl von zweiten Signalports des nachfolgenden Moduls 200 verbunden ist, ist eine Adressierung der einzelnen Erweiterungs-Slavemodule nicht mehr notwendig.

Sind die ersten, zweiten und dritten Signalports 211, 212, 213, 113 leitungsgebundene Punkt-zu-Punkt-Kommunikations-Ports, sind diese bevorzugt an Gehäuseseiten der Module herausgeführt, wobei die Anzahl der dritten Signalports gemeinsam an einer ersten Gehäuseseite eines jeweiligen Moduls und, soweit vorhanden, die ersten und zweiten Signalports gemeinsam an einer zweiten Gehäuseseite des jeweiligen Moduls, die der ersten Gehäuseseite gegenüberliegt, angeordnet sind. Auf diese Weise lassen sich die Port-Verbindungen auf einfache Weise, wie bei Fig. 2 zu sehen, auf die jeweils andere Gehäuseseite rangieren.

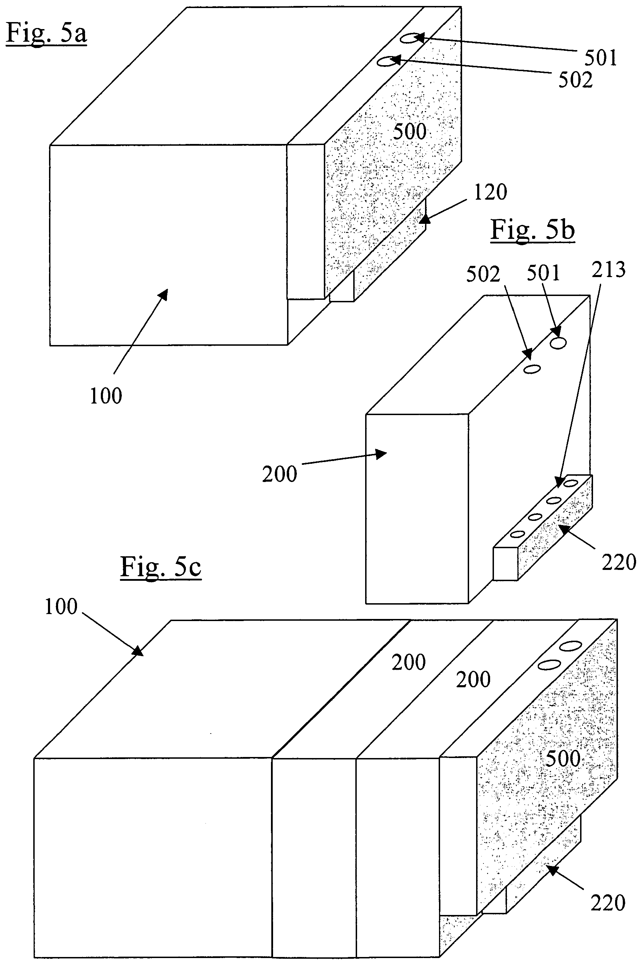

Sind die ersten, zweiten und dritten Signalports 211, 212, 213, 113 an einer Steck- oder Klemmkomponente 220 bzw. 120 angeschlossen bzw. integriert, wie bei Fig. 5a und 5b schematisch dargestellt, wird durch einfaches modulares Aneinanderstecken der einzelnen Module jedes Modul bzw. dessen Verarbeitungslogik automatisch auf den jeweils nächsten Punkt-zu-Punkt-Kommunikations-Port des Mastermoduls verschaltet. Auf der an einer Steck- oder Klemmkomponente 220 gegenüberliegenden Gehäuseseite eines Erweiterungs-Slavemoduls 200 ist folglich eine entsprechend komplementär ausgebildete Steck- oder Klemmkomponente angeordnet.

Insbesondere in einem solchen Fall umfasst ein Erweiterungs-Slavemodul 200 somit bevorzugt eine erste Reihe von Punkt-zu-Punkt-Kommunikation-Ports, welche auf des Figuren basierend den einen ersten Signalport 211 und die Anzahl von zweiten Signalports 212 umfasst, und eine zweite Reihe von Punkt-zu-Punkt-Kommunikation-Ports, welche auf Figuren basierend die Anzahl von dritten Signalports 213 umfasst. Z.B. ist dann jeweils der in der ersten Reihe von Ports erste Port 211 über eine Punkt-zu-Punkt-Kommunikationsverbindung mit der Verarbeitungslogik 215 des entsprechenden Slavemoduls 200 verbunden und die nachfolgenden Ports 212 der ersten Reihe von Ports sind jeweils der Reihe nach über eine Punkt-zu-Punkt-Kommunikationsverbindung mit den Ports 213 der zweiten Reihe von Ports des entsprechenden Slavemoduls, beginnend mit dem ersten Port in der zweiten Reihe von Punkt-zu-Punkt-Kommunikation-Ports, verbunden.

Fig. 3 zeigt beispielhaft einen Punkt-zu-Punkt-Kommunikations fähigen Busendteilnehmer 410, der an den vierten Port 113-4 der dritten Signalports 113 des Steuerungsmastermoduls 100 angeschlossen ist. Alternativ kann anstelle des Punkt-zu-Punkt-Kommunikations fähigen Busendteilnehmer 410 auch das bei Fig. 3 rechts dargestellte Slavemodul 200 als viertes Erweiterungsmodul in den Steuerungsblock integriert werden, welches dann automatisch mit dem vierten Port 113-4 der dritten Signalport 113 des Mastermoduls 100 verbunden wird. Dieses stellt gemäß Fig. 3 z.B. Standard digitale und analoge Eingangs-/Ausgangskanäle bereit, über welche entsprechende Busendteilnehmer 310 anschaltbar sind.

Jedes Master- und Slavemodul 100 bzw. 200 verfügt ferner zweckmäßig über zueinander ausgerichtete Spannungsverteilungseinrichtungen 501 und 502, so dass die Spannungsversorgung insgesamt über eine gemeinsame Spannungsversorgungseinrichtung 500 erfolgt. Eine solche Spannungsversorgungseinrichtung 500 kann z.B., wie in den Fig. 5a bis 5c zu sehen eine Art Abschlusseinrichtung bilden, welche ebenfalls entsprechend ausgerichtete Spannungsverteilungseinrichtungen 501 und 502 besitzt. In einem solchen Fall können z.B. die Erweiterungs-Slavemodule zwischen das Steuerungs-Mastermodul und die Spannungsversorgungseinrichtung 500, über welche die Spannung gespeist wird, angeordnet sein.

Fig. 4 zeigt eine weitere Prinzipskizze zur Veranschaulichung eines Prozessabbildes einer Ausführungsform, bei welcher ein Erweiterungs-Slavemodul noch wenigstens einen weiteren Punkt-zu-Punkt-Kommunikations-Port zur Verfügung stellt.

Das Steuerungs-Mastermodul 100 besitzt eine Steuerlogik 105 welche eine Einrichtung zur Verarbeitung von Signalen zur Punkt-zu-Punkt-Kommunikation und für eine Bus-Kommunikation umfasst und die bei Fig. 4 als "IO-Link Master" bezeichnet ist. Ferner umfasst die Steuerlogik 105 eine bei Fig. 4 mit 1051 gekennzeichnete Einrichtung zum Datenaustausch mit einem an das Steuerungs-Mastermodul 100 angeschalteten Feldbus.

Das Steuerungs-Mastermodul 100 besitzt im dargestellten Beispiel wiederum vier Punkt-zu-Punkt-Kommunikations-Ports 113-1, 113-2, 113-3 und 113-4. Über den Port 113-1 wird z.B. ein Sollwert an einen Busendteilnehmer ausgegeben, über den Port 113-3 ein Messwert von einem Busendteilnehmer eingelesen und über den Port 113-3 ein Schaltsignal über einen Busendteilnehmer erfasst. Am Port 113-4 ist ebenfalls über eine Punkt-zu-Punkt-Kommunikationsverbindung ein Erweiterungsmodul 200 als Slavemodul angeschaltet. Das Slavemodul 200 stellt als Signalports 214 eine Anzahl von sieben digitalen Ein-/Ausgängen zur Verfügung sowie einen Punkt-zu-Punkt-Kommunikations-Port, an welchen ein Punkt-zu-Punkt-Kommunikations fähiger Busendteilnehmer 410 angeschlossen ist.

Ferner umfasst das Slavemodul 200 eine bei Fig. 4 als "IO-Link Slave" bezeichnete Verarbeitungslogik 215 zur Verarbeitung von Signalen zur Punkt-zu-Punkt-Kommunikation sowie zur Verarbeitung von digitalen Standard-Eingangskanalsignalen.

Wie schematisch dargestellt werden sowohl das von dem Busendteilnehmer 410 kommende Punkt-zu-Punkt-Protokoll als auch die sieben digitalen Standard-Eingangskanalsignale durch die Verbarbeitungslogik 215 verarbeitet und innerhalb eines Punkt-zu-Punkt-kommunikationssignals zum Mastermodul getunnelt. Das zwischen dem Mastermodul 100 und dem Feldbus ausgetauschte Prozessabbild wird somit im vorliegenden Beispiel durch einen Telegrammaufbau repräsentiert, welcher in einem ersten Telegrammbereich Daten betreffend den "Sollwert", in einem zweiten Telegrammbereich Daten betreffend das "Schaltsignal", in einem dritten Telegrammbereich Daten betreffend den "Messwert" und in einem vierten Telegrammbereich Daten betreffend das Erweiterungsmodul umfasst. Der vierte Telegrammbereich ist im dargestellten Beispiel unterteilt in zwei Sub-Bereiche, welche die Daten betreffend das Punkt-zu-Punkt-Protokoll bzw. die sieben digitalen Standard-Eingangskanalsignale umfassen.

Dem Fachmann ist anhand vorstehender Beschreibung offensichtlich, dass für die Punkt-zu-Punkt-Kommunikation auch sicherheitsgerichtete Protokolle einsetzbar sind, welche dementsprechend auch für den Einsatz von Sicherheitssensoren und -aktoren geeignet sind.

## Patentansprüche

1. Ein-/Ausgangskanal-Steuerungsblock, welcher eine Anzahl von aufeinanderfolgenden Ein-/Ausgangs-Modulen umfasst, wobei das erste ein Ein-/Ausgangs-Steuerungs-Mastermodul (100) ist und die nachfolgenden Ein-/Ausgangs-Erweiterungs-Slavemodule (200) sind,
wobei
jedes Erweiterungs-Slavemodul eine Verarbeitungslogik (215) umfasst sowie jeweils einen ersten Signalport (211) und jeweils eine gleiche Anzahl von zweiten Signalports (212) und eine gleiche Anzahl von dritten Signalports (213) besitzt,
wobei der erste Signalport mit der Verarbeitungslogik (215) desselben Erweiterungs-Slavemoduls (200) verbunden ist,
wobei zu der Verarbeitungslogik (215) eine Anzahl von vierten Signalports (214) gehört, die mit der Verarbeitungslogik (215) durch Verbindungen zum Verbinden von Ein-/Ausgangs-Busendteilnehmer, wie z.B. Sensoren und Aktoren (310), verbunden snd, und jeweils ein zweiter Signalport (212) eines Erweiterungs-Slavemoduls (200) mit einem dritten Signalport (213) des selben Erweiterungs-Slavemoduls (200) verbunden ist,
und wobei
das Steuerungs-Mastermodul ebenfalls eine Anzahl von dritten Signalports (113) besitzt und eine Steuerlogik (105) zum Datenaustausch mit einem Datenbus und zum gezielten Ansteuern dieser dritten Signalports (113) umfasst und mit der Anzahl von Erweiterungs-Slavemodulen derart verbunden ist, dass jeweils der gleiche aus der Anzahl der dritten Signalports eines vorangehenden Moduls mit dem ersten Signalport eines nachfolgenden Moduls verbunden ist, und jeder weitere Signalport der Anzahl von dritten Signalports mit jeweils einem Signalport der Anzahl von zweiten Signalports des nachfolgenden Moduls verbunden ist, wobei die ersten, zweiten und dritten Signalports zur Signalübertragung mittels Punkt-zu-Punkt-Kommunikation angepasst sind,
sodass die Anzahl von steuerbaren Anschlüssen eines Ein-/Ausgangs-Steuerungs-Mastermoduls (100) individuell erweiterbar ist,
wobei jedes Erweiterungs-Slavemodul eine erste Reihe von Punkt-zu-Punkt-Kommunikation-Ports (211, 212) und eine zweiten Reihe von Punkt-zu-Punkt-Kommunikation-Ports (213) integriert, wobei der in der ersten Reihe von Ports erste Port der erste Signalport (211) des jeweiligen Erweiterungs-Slavemoduls (200) ist und über eine Punkt-zu-Punkt-Kommunikationsverbindung mit der Verarbeitungslogik (215) desselben Erweiterungs-Slavemoduls (200) verbunden ist und wobei die nachfolgenden Ports der ersten Reihe von Ports die zweiten Signalports (212) desselben Erweiterungs-Slavemoduls (200) sind und jeweils der Reihe nach über eine Punkt-zu-Punkt-Kommunikationsverbindung mit den Ports der zweiten Reihe von Ports, beginnend mit dem ersten Port in der zweiten Reihe von Ports, verbunden sind, welche die dritten Signalports (213) desselben Erweiterungs-Slavemoduls (200) sind.

2. Ein-/Ausgangs-Steuerungs-Mastermodul zur Ansteuerung von Ein-/Ausgängs-Erweiterungs-Slavemodulen für einen Ein-/Ausgangskanal-Steuerungsblock nach Anspruch 1, wobei das Steuerungs-Mastermodul (100) ebenfalls eine Anzahl von dritten Signalports (113) besitzt und eine Steuerlogik (105) zum Datenaustausch mit einem Datenbus und zum gezielten Ansteuern dieser dritten Signalports (113) umfasst und die Verbindung mit der Anzahl von Erweiterungs-Slavemodulen derart bereitzustellen ist, dass ein Signalport aus der Anzahl der dritten Signalports (113) des Steuerungs-Mastermoduls mit dem ersten Signalport (211) eines nachfolgenden Moduls verbunden ist, und jeder weitere Signalport der Anzahl von dritten Signalports des Steuerungs-Mastermoduls mit jeweils einem Signalport der Anzahl von zweiten Signalports des nachfolgenden Moduls verbunden ist.

3. Erweiterungs-Slavemodul für ein Steuerungs-Mastermodul oder einen Steuerungsblock nach einem der vorstehenden Ansprüche, welches eine Verarbeitungslogik (215) umfasst sowie jeweils einen ersten Signalport (211) und jeweils eine gleiche Anzahl von zweiten Signalports (212) und eine gleiche Anzahl von dritten Signalports (213) besitzt, wobei der erste Signalport mit der Verarbeitungslogik dieses Erweiterungs-Slavemoduls verbunden ist, wobei zu der Verarbeitungslogik (215) eine Anzahl von vierten Signalports (214) gehören, die mit der Verarbeitungslogik (215) durch Verbindungen zum Verbinden von Ein-/Ausgangs-Busendteilnehmern verbunden sind, und jeweils ein zweiter Signalport dieses Erweiterungs-Slavemoduls mit einem dritten Signalport dieses Erweiterungs-Slavemoduls verbunden ist, wobei das Erweiterungs-Slavemodul eine erste Reihe von Punkt-zu-Punkt-Kommunikation-Ports (211, 212) und eine zweiten Reihe von Punkt-zu-Punkt-Kommunikation-Ports (213) integriert, wobei der in der ersten Reihe von Ports erste Port der erste Signalport (211) dieses Erweiterungs-Slavemoduls (200) ist und über eine Punkt-zu-Punkt-Kommunikationsverbindung mit der Verarbeitungslogik (215) dieses Erweiterungs-Slavemoduls (200) verbunden ist und wobei die nachfolgenden Ports der ersten Reihe von Ports die zweiten Signalports (212) dieses Erweiterungs-Slavemoduls (200) sind und jeweils der Reihe nach über eine Punkt-zu-Punkt-Kommunikationsverbindung mit den Ports der zweiten Reihe von Ports, beginnend mit dem ersten Port in der zweiten Reihe von Ports, verbunden sind, welche die dritten Signalports (213) dieses Erweiterungs-Slavemoduls (200) sind.

4. Erweiterungs-Slavemodul nach Anspruch 3, wobei der erste Signalport (211), die zweiten Signalports (212) und die dritten Signalports (213) stets an der gleichen Position angeordnet sind.

5. Modul oder Block nach einem der vorstehenden Ansprüche, wobei die Signalports zur kabelgebundenen oder zur ungebunden Signalübertragung ausgebildet sind.

6. Steuerungs-Mastermodul oder Steuerungsblock nach vorstehendem Anspruch, wobei die Steuerlogik eine Einrichtung zur Verarbeitung von Signalen zur Punkt-zu-Punkt-Kommunikation und für eine Bus-Kommunikation besitzt.

7. Modul oder Block nach einem der vorstehenden Ansprüche, wobei die Verarbeitungslogik eine Einrichtung zur Verarbeitung von Signalen zur Punkt-zu-Punkt-Kommunikation besitzt.

8. Modul oder Block nach vorstehendem Anspruch, wobei die Verarbeitungslogik zur Verarbeitung von digitalen oder analogen Standard-Ein-/Ausgangskanalsignalen ausgebildet ist.

9. Modul oder Block nach einem der vorstehenden Ansprüche, wobei die vierten Ports insbesondere digitale oder analoge Standard-Ein-/Ausgangskanalsignale bereitstellen.

10. Modul oder Block nach einem der vorstehenden Ansprüche, wobei die Anzahl der dritten Signalports gemeinsam an einer ersten Gehäuseseite und, soweit vorhanden, die ersten und zweiten Signalports gemeinsam an einer zweiten Gehäuseseite, die der ersten gegenüberliegt, angeordnet sind.

11. Modul oder Block nach einem der vorstehenden Ansprüche, wobei die ersten, zweiten und dritten Signalports an einer Steck- oder Klemmkomponente angeschlossen bzw. integriert sind.

12. Modul oder Block nach einem der vorstehenden Ansprüche, wobei die Punkt-zu-Punkt-Kommunikation auf einem sicherheitsgerichteten Protokoll basiert, welches für den Einsatz von Sicherheitssensoren und -aktoren geeignet ist.

13. Block nach einem der vorstehenden Ansprüche, wobei die Erweiterungs-Slavemodule zwischen dem Steuerungs-Mastermodul und einer Spannungsversorgungseinrichtung (500) angeordnet sind, und jedes Modul über zueinander ausgerichtete Spannungsverteilungseinrichtungen (501, 502) verfügt, so dass alle mittels einer über die Spannungsversorgungseinrichtung eingespeisten Spannung betreibbar sind.

## Claims

1. An input/output channel control block that comprises a number of successive input/output modules, wherein the first module is an input/output control master module (100) and the subsequent modules are input/output expansion slave modules (200);
wherein each expansion slave module comprises a processing logic unit (215) and a respective first signal port (211) and a respective equal number of second signal ports (212) and an equal number of third signal ports (213);
wherein the first signal port is connected to the processing logic unit (215) of the same expansion slave module (200);
wherein the processing logic unit (215) has associated therewith a number of fourth signal ports (214) which are connected to the processing logic unit (215) via links for connecting input/output bus end subscribers such as sensors and actuators (310), and wherein a respective second signal port (212) of an expansion slave module (200) is connected to a third signal port (213) of the same expansion slave module (200); and
wherein the control master module likewise has a number of third signal ports (113) and comprises a control logic unit (105) for data exchange with a data bus and for selectively driving the third signal ports (113), and is connected to the number of expansion slave modules in such a manner that a respective same port from the number of third signal ports of a preceding module is connected to the first signal port of a subsequent module, and each additional signal port of the number of third signal ports is connected to a respective signal port of the number of second signal ports of the subsequent module, wherein the first, second, and third signal ports are configured for signal transfer via point-to-point communication, so that the number of drivable ports of an input/output control master module (100) is extendable individually;
wherein each expansion slave module integrates a first series of point-to-point communication ports (211, 212) and a second series of point-to-point communication ports (213), wherein the first port in the first series of ports is the first signal port (211) of the respective expansion slave module (200) and is connected via a point-to-point communication link to the processing logic unit (215) of the same expansion slave module (200), and wherein the subsequent ports of the first series of ports are the second signal ports (212) of the same expansion slave module (200) and are each connected in turn via a point-to-point communication link to the ports of the second series of ports beginning with the first port in the second series of ports, which are the third signal ports (213) of the same expansion slave module (200).

2. An input/output control master module for driving input/ output expansion slave modules for an input/output channel control block according to claim 1, wherein the control master module (100) likewise has a number of third signal ports (113) and comprises a control logic unit (105) for data exchange with a data bus and for selectively driving the third signal ports (113), and wherein the connection to the number of expansion slave modules is to be provided such that a signal port from the number of third signal ports (113) of the control master module is connected to the first signal port (211) of a subsequent module, and each further signal port of the number of third signal ports of the control master module is connected to a respective signal port of the number of second signal ports of the subsequent module.

3. An expansion slave module for a control master module or a control block according to any one of the preceding claims, comprising a processing logic unit (215) and a respective first signal port (211) and a respective equal number of second signal ports (212) and an equal number of third signal ports (213), wherein the first signal port is connected to the processing logic unit of this same expansion slave module; wherein the processing logic unit (215) has associate therewith a number of fourth signal ports (214) which are connected to the processing logic unit (215) via links for connecting input/output bus end subscribers, and wherein a respective second signal port of this same expansion slave module is connected to a third signal port of this same expansion slave module; wherein the expansion slave module integrates a first series of point-to-point communication ports (211, 212) and a second series of point-to-point communication ports (213), wherein the first port in the first series of ports is the first signal port (211) of this respective expansion slave module (200) and is connected via a point-to-point communication link to the processing logic unit (215) of this same expansion slave module (200), and wherein the subsequent ports of the first series of ports are the second signal ports (212) of this same expansion slave module (200) and are each connected in turn via a point-to-point communication link to the ports of the second series of ports, beginning with the first port in the second series of ports, which are the third signal ports (213) of this same expansion slave module (200).

4. The expansion slave module according to claim 3, wherein the first signal port (211), the second signal ports (212), and the third signal ports (213) are always arranged at a consistent position.

5. The module or block according to any one of the preceding claims, wherein the signal ports are configured for wired or wireless signal transfer.

6. The control master module or control block according to the preceding claim, wherein the control logic unit comprises means for processing signals for point-to-point communication and for a bus communication.

7. The module or block according to any one of the preceding claims, wherein the processing logic unit comprises means for processing signals for point-to-point communication.

8. The module or block according to the preceding claim,
wherein the processing logic unit is configured for processing digital or analogue standard input/output channel signals.

9. The module or block according to any one of the preceding claims, wherein the fourth ports in particular provide digital or analogue standard input/output channel signals.

10. The module or block according to any one of the preceding claims, wherein the number of third signal ports are all arranged on a first housing side and, insofar as provided, the first and second signal ports are all arranged on a second housing side opposite the first housing side.

11. The module or block according to any one of the preceding claims, wherein the first, second and third signal ports are connected to or integrated into a plug-in or clamp component.

12. The module or block according to any one of the preceding claims, wherein the point-to-point communication is based on a safety-oriented protocol that is suitable for the use of safety sensors and safety actuators.

13. The block according to any one of the preceding claims,
wherein the expansion slave modules are arranged between the control master module and a voltage supply unit (500), and wherein each module has voltage distribution means (501, 502) aligned with each other, such that all modules can be operated by a voltage supplied via the voltage supply unit.

## Revendications

1. Bloc de commande de canal d'entrée/de sortie, lequel comporte un certain nombre de modules d'entrée/de sortie successifs, le premier étant un module maître de commande d'entrée/de sortie (100) et les suivants étant des modules esclaves d'extension d'entrée/de sortie (200),
dans lequel :
chaque module esclave d'extension comporte une logique de traitement (215) et possède respectivement un premier port de signal (211) et respectivement un nombre identique de deuxièmes ports de signal (212) et un nombre identique de troisièmes ports de signal (213),
dans lequel le premier port de signal est relié à la logique de traitement (215) du même module esclave d'extension (200),
dans lequel un certain nombre de quatrièmes ports de signal (214) font partie de la logique de traitement (215) et sont reliés à la logique de traitement (215) par des liaisons destinées à relier des abonnés finaux du bus d'entrée/de sortie, comme par exemple des capteurs et des actionneurs (310), et respectivement un deuxième port de signal (212) d'un module esclave d'extension (200) est relié à un troisième port de signal (213) du même module esclave d'extension (200),
et dans lequel :
le module maître de commande possède également un certain nombre de troisièmes ports de signal (113) et comporte une logique de commande (105) pour l'échange de données avec un bus de données et pour la commande ciblée de ces troisièmes ports de signal (113) et est relié au certain nombre de modules esclaves d'extension, de telle manière que respectivement le même port de signal du certain nombre de troisièmes ports de signal d'un module précédent est relié au premier port de signal d'un module suivant, et que chaque autre port de signal du certain nombre de troisièmes ports de signal est relié à respectivement un port de signal du certain nombre de deuxièmes ports de signal du module suivant, dans lequel les premiers, deuxièmes et troisièmes ports de signal sont adaptés à la transmission de signaux au moyen d'une communication point à point,
de sorte que le certain nombre de raccords pouvant être commandés d'un module maître de commande d'entrée/de sortie (100) peut être étendu individuellement,
dans lequel chaque module esclave d'extension intègre une première rangée de ports de communication point à point (211, 212) et une deuxième rangée de ports de communication point à point (213), le premier port dans la première rangée de ports étant le premier port de signal (211) du module esclave d'extension (200) respectif et étant relié à la logique de traitement (215) du même module esclave d'extension (200) par une liaison de communication point à point et les ports suivants de la première rangée de ports étant les deuxièmes ports de signal (212) du même module esclave d'extension (200) et étant reliés respectivement dans l'ordre par une liaison de communication point à point aux ports de la deuxième rangée de ports, en commençant par le premier port dans la deuxième rangée de ports, lesquels sont les troisièmes ports de signal (213) du même module esclave d'extension (200).

2. Module maître de commande d'entrée/de sortie pour la commande de modules esclaves d'extension d'entrée/de sortie pour un bloc de commande de canal d'entrée/de sortie selon la revendication 1, où le module maître de commande (100) possède également un certain nombre de troisièmes ports de signal (113) et comporte une logique de commande (105) pour l'échange de données avec un bus de données et pour la commande ciblée de ces troisièmes ports de signal (113) et la liaison au certain nombre de modules esclaves d'extension doit être établie de telle manière qu'un port de signal du certain nombre de troisièmes ports de signal (113) du module maître de commande est relié au premier port de signal (211) d'un module suivant, et que chaque autre port de signal du certain nombre de troisièmes ports de signal du module maître de commande est relié à respectivement un port de signal du certain nombre de deuxièmes ports de signal du module suivant.

3. Module esclave d'extension pour un module maître de commande ou bloc de commande selon l'une quelconque des revendications précédentes, lequel comporte une logique de traitement (215) et possède respectivement un premier port de signal (211) et respectivement un nombre identique de deuxièmes ports de signal (212) et un nombre identique de troisièmes ports de signal (213), dans lequel le premier port de signal est relié à la logique de traitement de ce module esclave d'extension, un certain nombre de quatrièmes ports de signal (214) font partie de la logique de traitement (215) et sont reliés à la logique de traitement (215) par des liaisons destinées à relier des abonnés finaux du bus d'entrée/de sortie, et respectivement un deuxième port de signal de ce module esclave d'extension est relié à un troisième port de signal de ce module esclave d'extension, dans lequel le module esclave d'extension intègre une première rangée de ports de communication point à point (211, 212) et une deuxième rangée de ports de communication point à point (213), le premier port dans la première rangée de ports étant le premier port de signal (211) de ce module esclave d'extension (200) et étant relié à la logique de traitement (215) de ce module esclave d'extension (200) par une liaison de communication point à point et les ports suivants de la première rangée de ports étant les deuxièmes ports de signal (212) de ce module esclave d'extension (200) et étant reliés respectivement dans l'ordre par une liaison de communication point à point aux ports de la deuxième rangée de ports, en commençant par le premier port dans la deuxième rangée de ports, lesquels sont les troisièmes ports de signal (213) de ce module esclave d'extension (200).

4. Module esclave d'extension selon la revendication 3, dans lequel le premier port de signal (211), les deuxièmes ports de signal (212) et les troisièmes ports de signal (213) sont agencés constamment dans la même position.

5. Module ou bloc selon l'une quelconque des revendications précédentes, dans lequel les ports de signal sont conçus pour la transmission de signaux filaire ou sans fil.

6. Module maître de commande ou bloc de commande selon la revendication précédente, dans lequel la logique de commande possède un dispositif de traitement de signaux pour la communication point à point et pour une communication par bus.

7. Module ou bloc selon l'une quelconque des revendications précédentes, dans lequel la logique de traitement possède un dispositif de traitement de signaux pour la communication point à point.

8. Module ou bloc selon la revendication précédente, dans lequel la logique de traitement est conçue pour traiter des signaux numériques ou analogiques de canal d'entrée/de sortie standards.

9. Module ou bloc selon l'une quelconque des revendications précédentes, dans lequel les quatrièmes ports fournissent en particulier des signaux numériques ou analogiques de canal d'entrée/de sortie standards.

10. Module ou bloc selon l'une quelconque des revendications précédentes, dans lequel le certain nombre de troisièmes ports de signal sont agencés conjointement sur une première face de boîtier et, s'il y en a, les premiers et les deuxièmes ports de signal sont agencés conjointement sur une deuxième face de boîtier opposée à la première.

11. Module ou bloc selon l'une quelconque des revendications précédentes, dans lequel les premiers, deuxièmes et troisièmes ports de signal sont raccordés à un composant d'enfichage ou de serrage ou intégrés sur celui-ci.

12. Module ou bloc selon l'une quelconque des revendications précédentes, dans lequel la communication point à point se base sur un protocole de sécurité, lequel est adapté à l'utilisation de capteurs et d'actionneurs de sécurité.

13. Bloc selon l'une quelconque des revendications précédentes, dans lequel les modules esclaves d'extension sont agencés entre le module maître de commande et un dispositif d'alimentation en tension (500), et chaque module dispose de dispositifs de distribution de tension (501, 502) orientés les uns par rapport aux autres, de sorte que tous peuvent fonctionner au moyen d'une tension injectée par l'intermédiaire du dispositif d'alimentation en tension.
